# EUROPEAN PATENT SPECIFICATION

(11) **EP 4 044 784 B1**
(45) Date of publication and mention of the grant of the patent: **19.02.2025**
(21) Application number: 19948516.0
(22) Date of filing: 10.10.2019
(51) Int. Cl.: H05K 13/00, H05K 13/08, H05K 13/02

(54) **STORAGE CABINET**
LAGERSCHRANK
ARMOIRE DE STOCKAGE

(43) Date of publication of application: 17.08.2022
(73) Proprietor: Fuji Corporation, Chiryu-shi, Aichi 472-8686 (JP)
(72) Inventor: OKI, Hideaki, Chiryu-shi, Aichi 472-8686 (JP); KAWAGUCHI, Masanori, Chiryu-shi, Aichi 472-8686 (JP); MATSUMOTO, Masanari, Chiryu-shi, Aichi 472-8686 (JP); TANAKA, Katsuaki, Chiryu-shi, Aichi 472-8686 (JP)
(74) Representative: Grünecker Patent- und Rechtsanwälte PartG mbB
(86) International application number: PCT/JP2019/040079
(87) International publication number: WO 2021/070339

(56) References cited:
- WO-A1-2018/127956
- WO-A1-2019/138548
- WO-A1-2019/193969
- JP-A- 2005 244 175
- JP-A- 2018 050 002
- JP-A- 2018 050 002
- US-A1- 2020 339 353

## Description

### Technical Field

The present description discloses a technology relating to a storage cabinet.

### Background Art

A storage cabinet described in Patent Literature 1 stores a mounting head and a feeder device. In addition, in an exchange supporting apparatus described in Patent Literature 1, when a setup change is carried out to change the types of boards to be produced, the exchange supporting apparatus determines a mounting head and a feeder device which are to be mounted on a component mounter from mounting heads and feeder devices which are stored in the storage cabinet based on production job information and maintenance information. The exchange supporting apparatus searches for a feeder device which holds a reel accommodating a type of components needed for a production after the setup change. Further, a guide section of the exchange supporting apparatus informs an operator of a mounting head and a feeder device which are to be delivered from the storage cabinet.

In a nozzle managing machine of Patent Literature 2, a setting control section sets a suction nozzle required by a component mounter on a nozzle tray based on information received from at least one of the component mounter and a management device.

### Patent Literature

Patent Literature 1: JP-A-2017-37886
Patent Literature 2: International Publication No. WO2014/069016

WO 2019 138548 A1 discloses a storage device that comprises an acquisition unit and a management unit. When a case that houses multiple housable items enters a storage facility, the acquisition unit uses a radio device provided at the entrance of the storage facility and effects radio communication with a first wireless tag attached to the case and a second wireless tag attached to each of the multiple housable items. The acquisition unit then acquires identification information retained in the first wireless tag for identifying the casing and discrimination information retained in the second wireless tag for discriminating among the multiple housable items. The management unit associates the identification information and the discrimination information acquired by the acquisition unit and manages the association therebetween.

It is therefore the object of the present invention to provide a storage cabinet to enhance management of elements to be supplied to a board machine.

### Summary of the Invention

This object is solved by the subject matter of independent claim 1.

Embodiments are defined by the dependent claims.

### Technical Problem

For production of board products using a board work machine, both a supply component such as an article or the like which is mounted on a board by the board work machine and a device which is detachably provided on the board work machine for use in board work are necessary. In addition, since a combination of supply component and device necessary for production of board products changes as the type of board products to be produced changes, a supply component and a device which match a type of board products to be produced become necessary. Further, when a supply component and a device are stored in such a state that the supply component is incorporated in the device as with the reel and the feeder device described above, combinations of a supply component and a device for delivery are limited.

In view of these situations, according to the present description, there is disclosed a storage cabinet which can store a supply component and a device separately and which can deliver a supply component and a device for use for a unit production which specifies a production of an identical type of board products in an associated fashion.

### Solution to Problem

The present description discloses a storage cabinet including a first storage section, a second storage section, a delivery section, and a moving section. The first storage section stores a supply component which is at least one of an article which is provided on a board by a board work machine configured to perform predetermined board work on the board and the board before the article is provided thereon. The second storage section stores a device which is detachably provided on the board work machine for use in the board work. The delivery section delivers the supply component and the device in an associated fashion which are used for a predetermined unit production included in a production plan which prescribes an order of unit productions which each specify a production of an identical type of board products using the board work machine. The moving section moves the supply component stored in the first storage section to the delivery section and moves the device stored in the second storage section to the delivery section. The device and the supply component are accommodated together in an accommodation case.

### Advantageous Effect of the Invention

With the configuration of the storage cabinet described above, the storage cabinet includes the first storage section, the second storage section, the delivery section, and the moving section. As a result, the storage cabinet can store the supply component in the first storage section and the device in the second storage section. In addition, with the storage cabinet described above, the moving section moves the supply component stored in the first storage section to the delivery section and moves the device stored in the second storage section to the delivery section, whereby the delivery section can deliver the supply component and the device in the associated fashion for use in the predetermined unit production.

### Brief Description of Drawings

Fig. 1 is a schematic view showing a configuration example of a board production facility.
Fig. 2 is a plan view showing an example of a state in which supply components and devices are accommodated in accommodation cases at an arrival section.
Fig. 3a is a front view showing an example of a storage cabinet.
Fig. 3b is a plan view of the storage cabinet shown in Fig. 3a.
Fig. 3c is a front view showing an example of a storage section of the storage cabinet shown in Fig. 3b.
Fig. 4 is a block diagram showing an example of control blocks of the storage cabinet.
Fig. 5a is a flowchart showing an example of a control procedure for a receiving operation of a supply component and a device.
Fig. 5b is a flowchart showing an example of a control procedure for a delivery operation of a supply component and a device.
Fig. 6 is a schematic diagram showing an example of a relationship among a first unit production, a second unit production, a first production time slot, and a second production time slot.
Fig. 7a is a schematic diagram showing a configuration example of a delivery section in which a first delivery section and a second delivery section are both formed into a rack.
Fig. 7b is a schematic diagram showing a configuration example of a delivery section in which a first delivery section and a second delivery section are both formed into a wheeled table.
Fig. 7c is a schematic diagram showing a configuration example of a delivery section in which a first delivery section is formed into a first wheeled table and a second delivery section is formed into a second wheeled table.
Fig. 7d is a schematic diagram showing a configuration example of a delivery section in which a first delivery section is formed into a first rack and a second delivery section is formed into a second rack.

### Description of Embodiments

### 1. Embodiment

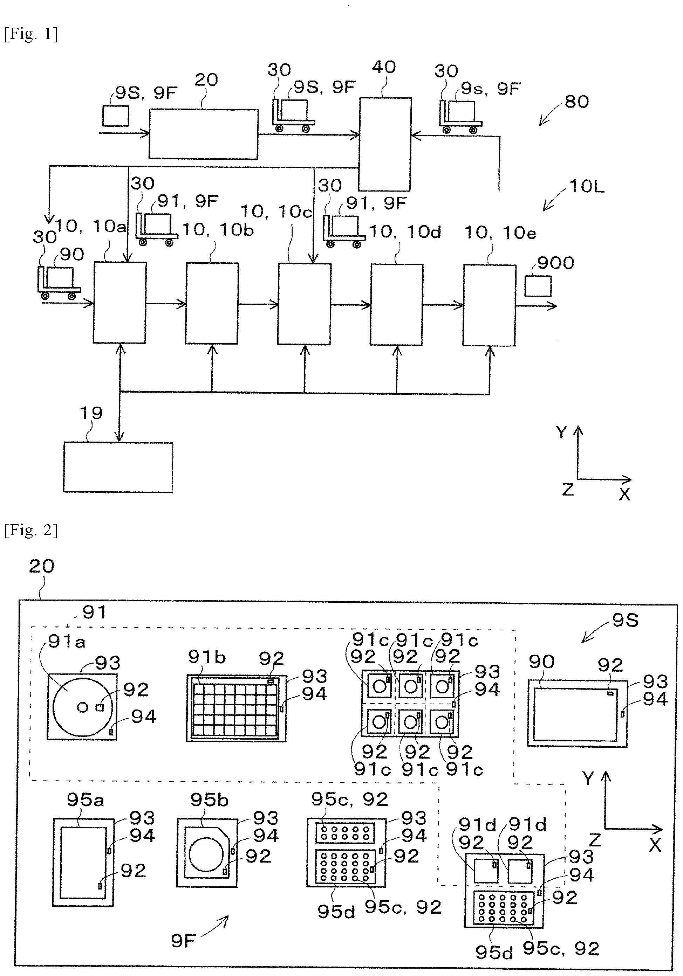

As shown in Fig. 1, storage cabinet 40 of an embodiment of the present description is provided in board production facility 80. Board production facility 80 includes board working line 10L, arrival section 20, conveyance vehicle 30, and storage cabinet 40.

### 1-1. Board Working Line 10L

In board working line 10L, predetermined board work is performed on board 90. The type and number of board work machines 10 constituting board working line 10L are not limited. As shown in Fig. 1, board working line 10L of the present embodiment includes multiple (five) board work machines 10 such as printer 10a, printing inspection machine 10b, component mounter 10c, reflow furnace 10d, and appearance inspection machine 10e, and board 90 is conveyed sequentially in this order by a board conveyance device.

Printer 10a prints solder in multiple component mounting positions on board 90. Solder that is printed on board 90 has a predetermined viscosity, and the solder so printed functions as a bonding material for bonding board 90 and a component that is mounted on board 90 together. As shown in Fig. 2, solder is accommodated in solder accommodation container 91c. For example, a bottomed cylindrical or tubular sealable container can be used as solder accommodation container 91c.

Printing inspection machine 10b inspects a print state of solder which is printed by printer 10a. Component mounter 10c mounts multiple components on board 90 on which solder is printed. Component mounter 10c may be provided one, or multiple component mounters 10c may be provided. In the case that multiple component mounters 10c are provided, those multiple component mounters 10c can share a mounting operation for mounting multiple components on board 90.

Component mounter 10c includes a component supply device for supplying components which are mounted on board 90. The component supply device can supply components using, for example, feeder 95b including reel 91a, tray 91b, and the like which are shown in Fig. 2. A component tape (a carrier tape) which accommodates components thereon is wound around reel 91a. Reel 91a is rotatably and detachably provided in feeder 95b, and a distal end portion of the component tape is drawn out to a component take-out or pickup section provided in feeder 95b, whereby components are sequentially supplied. Reel 91a can supply, for example, a relatively small component such as a chip component.

Multiple components are arranged on tray 91b. Tray 91b can supply a relatively large component such as, for example, a Quad Flat Package (QFP), a Ball Grid Array (BGA), and the like. The component supply device can also supply, for example, components accommodated in parts accommodating container 91d. Multiple components are accommodated in parts accommodating container 91d without being arranged.

Further, mounting head 95a is detachably (in an exchangeable fashion) provided on component mounter 10c. At least one holding member 95c is provided detachably (in an exchangeable fashion) provided on mounting head 95a. For example, a suction nozzle, a chuck, or the like can be used as holding member 95c. Component mounter 10c picks up and holds a component supplied by the component supply device and mounts the component on board 90, which is positioned, by use of mounting head 95a and holding member 95c.

Holding member 95c can be changed as required in accordance with the type of a component to be mounted in a mounting process of mounting a component on board 90. For example, in the case that holding member 95c for use for a mounting process to be executed is not attached to mounting head 95a of component mounter 10c, holding member 95c accommodated in holding member accommodating device 95d can be attached to mounting head 95a. Holding member accommodating device 95d is capable of accommodating multiple holding members 95c in a detachable (exchangeable) fashion and is installed in a predetermined position inside component mounter 10c in a detachable (exchangeable) fashion.

Reflow furnace 10d heats board 90 on which multiple components are mounted by component mounter 10c to melt the solder printed thereon for soldering. Appearance inspection machine 10e inspects the mounting state or the like of the multiple components mounted on board 90 by component mounter 10c. In this way, in board working line 10L, board 90 is conveyed sequentially so that the production processes including the inspection process can be executed thereon for production of board product 900 by use of multiple (five) board work machines 10s. Board working line 10L can also include, as required, board work machines 10 such as, for example, a function inspection machine, a buffer device, a board supply device, a board flipping device, a shield mounting device, an adhesive application device, an ultraviolet ray irradiation device, and the like.

Multiple (five) board work machines 10 and management device 19, which make up board working line 10L, are provided so as to be capable of communicating with each other by a wired or wireless communication section. Management device 19 controls multiple (five) board work machines 10, which make up board working line 10L, to monitor operation situations of board working line 10L. Management device 19 stores various control data for controlling multiple (five) board work machines 10. Management device 19 transmits the control data to each of multiple (five) board work machines 10. On the other hand, each of multiple (five) board work machines 10 transmits an operation situation and a production situation to management device 19.

### 1-2. Arrival Section 20 and Conveyance Vehicle 30

In the present description, at least one of article 91 which is provided on board 90 by board work machine 10, which is configured to perform predetermined board work on board 90, and board 90 on which any article 91 has not yet been mounted will be referred to as supply component 9S. In addition, a thing which is detachably provided on board work machine 10 for use for board work will be referred to as device 9F.

As has been described above, board working line 10L includes printer 10a. In this case, for example, solder accommodated in solder accommodation container 91c corresponds to article 91. In addition, for example, in the case of printer 10a configured to execute a printing process on board 90 by moving solder along a mask by a squeegee, the squeegee and the mask correspond to device 9F. Further, for example, in the case of a printer configured to apply solder on each of multiple printing positions on board 90 by a printing head, the printing head and a dispense head correspond to device 9F.

In addition, board working line 10L includes component mounter 10c. In this case, for example, a component accommodated in a component tape wound around reel 91a corresponds to article 91. A component accommodated on tray 91b corresponds to article 91. A component accommodated in parts accommodating container 91d corresponds to article 91. Mounting head 95a which is detachably provided on component mounter 10c corresponds to device 9F. Feeder 95b which is detachably provided in component mounter 10c corresponds to device 9F. Holding member 95c which is detachably provided on component mounter 10c via mounting head 95a corresponds to device 9F. Holding member accommodating device 95d which is detachably provided in component mounter 10c corresponds to device 9F.

Further, board working line 10L includes printing inspection machine 10b. In addition, board working line 10L includes appearance inspection machine 10e. In these cases, for example, an inspection head for inspecting an inspection target object (solder or a component) corresponds to device 9F. Board 90 on which any article 91 has not yet been mounted is conveyed to printer 10a shown in Fig. 1. That board 90 is included in supply component 9S.

When supply component 9S arrives at arrival section 20, predetermined landing work is performed. Then, supply component 9S is accommodated in accommodation case 93, and this accommodation case 93 is mounted on conveyance vehicle 30 and is conveyed to storage cabinet 40. Once supply component 9S is stored in storage cabinet 40, supply component 9S is then supplied to board working line 10L as required.

As shown in Fig. 2, identification code 92 is provided on supply component 9S. Identification code 92 stores identification information for identifying supply component 9S. For example, a one-dimensional code, a two-dimensional code, a wireless tag, or the like can be used for identification code 92. When supply component 9S arrives at arrival section 20, an operator at arrival section 20 issues identification information using, for example, the management device. In addition, the operator reads a barcode or the like which is provided on supply component 9S by a supplier (a vendor) using a barcode reader or the like. Then, the operator can also obtain supply component information for supply component 9S from a database in which the supply information for supply component 9S is registered. The operator stores at least the identification information of the identification information and the supply component information in identification code 92 using the management device.

The operator at arrival section 20 attaches identification code 92 which stores at least the identification information therein to supply component 9S and accommodates that supply component 9S in accommodation case 93. Accommodation case 93 need only accommodate at least one supply component 9S and hence can take various forms. Specific code 94 is provided on accommodation case 93. Specific code 94 stores specific information for specifying accommodation case 93. For example, a one-dimensional code, a two-dimensional code, a wireless tag, or the like can be used for specific code 94.

When accommodating supply component 9S in accommodation case 93, the operator reads specific code 94 using the reader and reads identification code 92 provided on that supply component 9S using the reader. As a result, a correspondence between the specific information which specifies accommodation case 93 accommodating supply component 9S and the identification information which identifies that supply component 9S is generated, and the correspondence so generated is transmitted to and stored in a storage section of management device 19. What is described above on supply component 9S also applies to a case in which device 9F arrives at arrival section 20.

Fig. 2 is a plan view showing an example of an accommodation state in which supply component 9S and device 9F are accommodated in accommodation case 93. Specifically speaking, Fig. 2 shows an example of a state in which reel 91a around which a component tape accommodating a component corresponding to article 91 is wound is accommodated in accommodation case 93. In addition, Fig. 2 shows an example of a state in which trays 91b each accommodating a component corresponding to article 91 are accommodated (loaded) in accommodation case 93. Tray 91b is accommodated in a packaging bag, and identification code 92 is attached to the packaging bag of tray 91b. Further, Fig. 2 shows an example of a state in which solder accommodation containers 91c each accommodating solder corresponding to article 91 are accommodated in accommodation case 93. In addition, Fig. 2 shows an example of a state in which substrate 90 on which any article 91 has not yet been provided is accommodated d in accommodation case 93.

Further, Fig. 2 shows an example of a state in which mounting head 95a, feeder 95b, holding member 95c, and holding member accommodating device 95d, which each correspond to device 9F, are accommodated individually in corresponding accommodation cases 93. Mounting head 95a and feeder 95b are individually accommodated in corresponding accommodation cases 93. Holding member 95c can be accommodated in an accommodation space which accommodates detachably holding member 95c and can also be accommodated detachably in holding member accommodating device 95d.

Accommodation case 93 can also accommodate supply component 9S and device 9F together. For example, parts accommodating containers 91d, each accommodating a component corresponding to article 91, and holding member accommodating device 95d and holding members 95c, each corresponding to device 9F, are accommodated together in accommodation case 93 shown in Fig. 2. In either of the cases, a shock absorbing member is provided in accommodation case 93, whereby vibration or the like which would be applied to supply components 9S and device 9F during conveyance or the like is reduced.

The operator at arrival section 20 mounts accommodation case 93 which accommodates therein at least one of supply component 9S and device 9F on conveyance vehicle 30. For example, the operator can pull conveyance vehicle 30. In addition, for example, a self-propelled unmanned conveyance vehicle (an automated guided vehicle (AGV) ), which does not have to be pulled by the operator, can also be used for conveyance vehicle 30. In the present embodiment, conveyance vehicle 30 adopts an unmanned conveyance vehicle.

Board working line 10L, arrival section 20, conveyance vehicle 30, and storage cabinet 40 are provided so as to be capable of communicating with each other by a wired or wireless communication section. When accommodation case 93 which accommodates at least one of supply component 9S and device 9F is mounted on conveyance vehicle 30, management device 19 transmits a conveyance command to conveyance vehicle 30. The conveyance command includes a conveyance destination of that accommodation case 93. Management device 19 selects storage cabinet 40 which can store that accommodation case 93 and determines a conveyance destination. When receiving the conveyance command, conveyance vehicle 30 conveys that accommodation case 93 to storage cabinet 40 which is designated as the conveyance destination.

Conveyance vehicle 30 can also convey at least one of supply component 9S and device 9F without using accommodation case 93. In addition, the operator can convey at least one of supply component 9S and device 9F without using conveyance vehicle 30. Further, at least a part of the work described as being performed by the operator can be automated using a conveyance device (for example, a belt conveyor), an actuator (for example, a robot arm and the like.), the management device, or the like.

### 1-3. Storage Cabinet 40

In this way, at least one of supply component 9S and device 9F that have arrived at arrival section 20 is conveyed to storage cabinet 40. In addition, at least one of supply component 9S and device 9F which become unnecessary in board working line 10L is conveyed to storage cabinet 40. Supply component 9S and device 9F which are conveyed to storage cabinet 40 are stored in storage cabinet 40 and are then conveyed to board working line 10L as required.

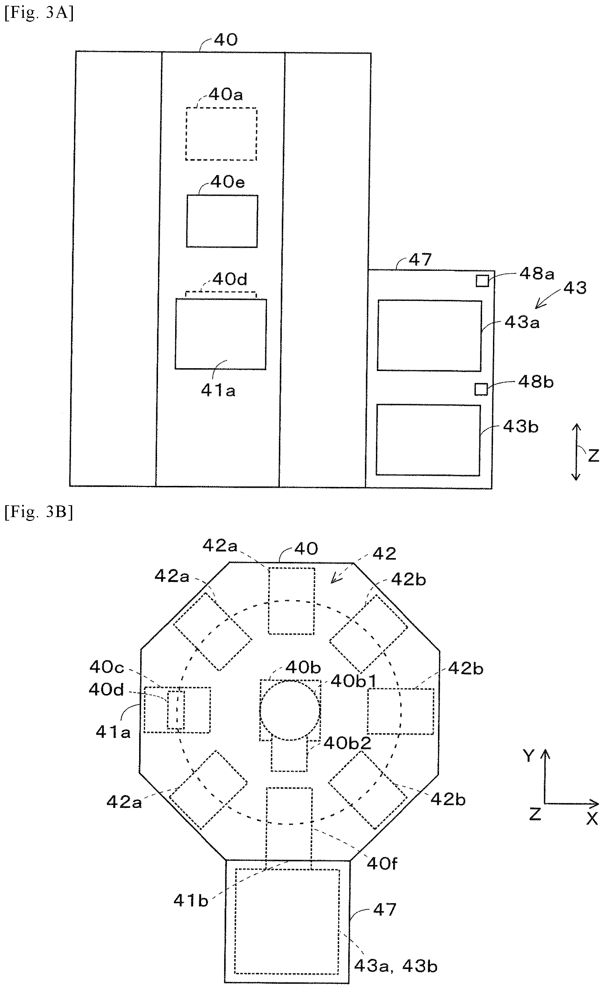

Storage cabinet 40 need only store supply component 9S and device 9F, and hence, storage cabinet 40 can take various forms. As shown in Figs. 3a and 3b, storage cabinet 40 of the present embodiment is formed in, for example, an octagonal prism shape. As shown in Figs. 3a to 3c, storage cabinet 40 includes first opening section 41a, second opening section 41b, storage section 42, delivery section 43, control device 40a, and moving device 40b. Storage section 42 includes first storage section 42a and second storage section 42b and can further include third storage section 42c. Delivery section 43 includes first delivery section 43a and second delivery section 43b. Delivery portion 43 can be formed into, for example, wheeled table 46 or rack 47.

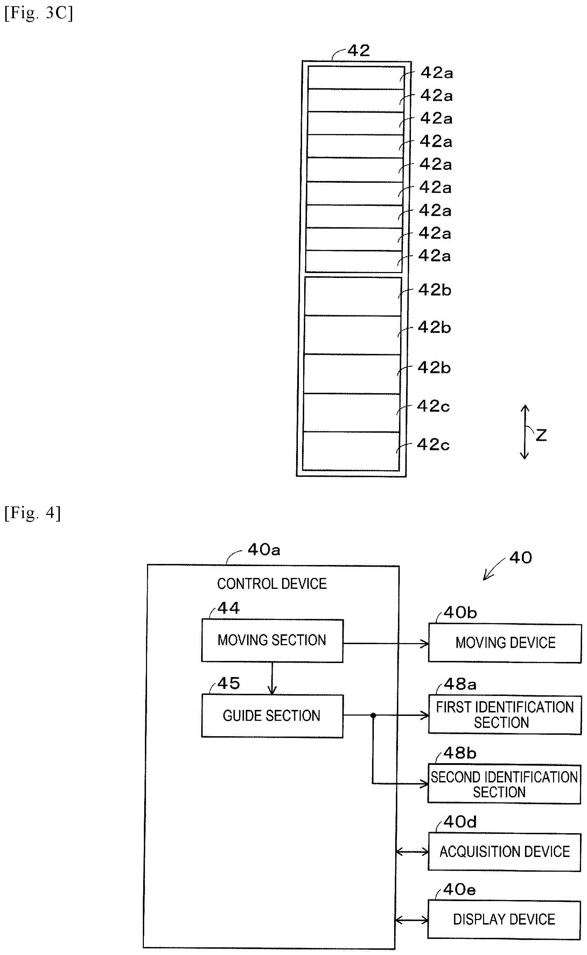

Further, as shown in Fig. 4, when taken as a control block, control device 40a includes moving section 44. Control device 40a can further include guide section 45. In addition, storage cabinet 40 can include at least one of work space 40c, acquisition device 40d, display device 40e, and delivery space 40f. As shown in Figs. 3a to 3c and 4, in the present embodiment, storage cabinet 40 includes all the parts and devices described above. Delivery section 43 is formed into rack 47.

### 1-3-1. Schematic Configuration of Storage Cabinet 40

As shown in Figs. 3a and 3b, first opening section 41a is provided in a front surface of storage cabinet 40, and second section 41b is provided in a side surface of storage cabinet 40. Supply component 9S and device 9F are received in and delivered out from first opening section 41a. First opening section 41a is formed larger than supply component 9S and device 9F so that supply component 9S and device 9F can be received in and delivered out from first opening section 41a.

At least one of supply component 9S and device 9F can be received in and delivered out via first opening section 41a while being accommodated in accommodation case 93. In this case, first opening section 41a is formed larger than accommodation case 93 so that accommodation case 93 can be received in and delivered out from first opening section 41a. Supply component 9S and device 9F are delivered out from second opening section 41b. What is described above about first opening section 41a will be true with second opening section 41b.

In addition, acquisition device 40d is provided in first opening section 41a. Acquisition device 40d reads identification code 92 provided on supply component 9S and acquires the identification information for identifying supply component 9S . Similarly, acquisition device 40d reads identification code 92 provided on device 9F and acquires the identification information for identifying device 9F. A known reader (for example, a code reader for reading a one-dimensional code and a two-dimensional code, a wireless reader for performing wireless communication with a wireless tag, or the like) can be used for acquisition device 40d.

As shown in Figs. 3a and 3b, acquisition device 40d is set above work space 40c provided in the vicinity of first opening section 41a. Acquisition device 40d reads identification code 92 provided on supply component 9S to acquire at least the identification information of the identification information and the supply component information when supply component 9S is received in via first opening section 41a. Similarly, acquisition device 40d reads identification code 92 provided on device 9F to acquire at least the identification information of the identification information and the device information on device 9F when device 9F is received in via first opening section 41a.

Acquisition device 40d can read specific code 94 provided on accommodation case 93 to acquire the specific information when accommodation case 93 is received in via first opening section 41a. In this case, acquisition device 40d can acquire the identification information of at least one of supply component 9S and device 9F which is accommodated in accommodation case 93 based on the correspondence between the specific information and the identification information.

As a result, with storage cabinet 40 of the present embodiment, acquisition device 40d is provided only in first opening section 41a. In addition, first opening section 41a functions both as the receiving section and the delivery section through which supply component 9S and device 9F can be received in or delivered out, while second opening section 41b functions exclusively as the delivery section through supply component 9S and device 9F can be delivered out.

Storage section 42 need only store both supply component 9S and device 9F and hence can take various forms. As shown in Fig. 3b, storage section 42 of the present embodiment is disposed in a circular shape when viewed in a vertical direction (a Z-axis direction). As shown in Fig. 3c, storage section 42 includes first storage sections 42a each configured to store supply component 9S and second storage sections 42b each configured to store device 9F.

The numbers and arrangements of first storage sections 42a and second storage sections 42b are changed as required. For example, at least one storage section 42 of multiple storage sections 42 can include only first storage section 42a, while at least one storage section 42 of the other storage sections 42 of multiple storage sections 42 can include only second storage section 42b. As shown in Fig. 3b, in storage cabinet 40 of the present embodiment, a part of first storage sections 42a or second storage sections 42b is eliminated so as to secure work space 40c and delivery space 40f.

Further, the shape and size (width, depth, and height) of first storage section 42a can be set so as to match supply component 9S to be stored therein, and the shape and size (width, depth, and height) of second storage section 42b can be set so as to match device 9F to be stored therein. In addition, storage section 42 can also store accommodation case 93 which accommodates at least one of supply component 9S and device 9F therein.

In this case, the shapes and sizes (width, depth, and height) of first storage section 42a and second storage section 42b can be set so as to match accommodation case 93. On the contrary, the shape and size (width, depth, and height) of accommodation case 93 can be set so as to match the shapes and sizes of first storage section 42a and second storage section 42b.

As shown in Fig. 3c, storage section 42 can also include third storage sections 42c which each store both supply component 9s and device 9F. Accommodation case 93 which accommodates both supply component 9S and device 9F (in which device 9F and supply component 9S are accommodated together) is stored in third storage section 42c. In addition, supply component 9S, device 9F, and accommodation case 93 can also be stored in suitable storage sections 42. In this case, storage section 42 where supply component 9S is stored is first storage section 42a. Storage section 42 where device 9F is stored is second storage section 42b. Storage section 42 where both supply component 9S and device 9F are stored is third storage section 42c. In the case that board production facility 80 includes multiple storage cabinets 40, supply component 9S, device 9F, and accommodation case 93 may be stored in any storage cabinets 40, as long as those storage cabinets 40 include suitable storage sections 42.

A production plan prescribes an order of unit productions UJO which each specify a production of an identical type of board products 900 using board work machines 10. For example, the production plan prescribes a production of multiple types (for example, three types) of board products 900 as in a production order of a production of a first type of board products 900, a production of a second type of board products 900, a production of a third type of board products 900, and the like. In addition, the production plan can also include a production number of board product 900 to be produced, a production period, a delivery time, supply component 9S and device 9F which are to be used, and the like. Further, in the case that there exist multiple board working lines 10L which can be used for production, the production plan can also include board working line or lines 10L for use for production. The production plan may be a production plan for one type of board products 900.

Delivery section 43 delivers out supply component 9S and device 9F in associated fashion which are to be used for a predetermined unit production UJ0 included in the production plan. In the present embodiment, delivery section 43 includes first delivery section 43a and second delivery section 43b. Supply component 9S for use for unit production UJ0 is delivered to first delivery section 43a. Device 9F for use for unit production UJ0 which uses supply component 9S delivered out from first storage section 43a is delivered to second delivery section 43b.

First delivery section 43a and second delivery section 43b can be formed into, for example, wheeled table 46 or rack 47 which can hold supply component 9S and device 9F. Wheeled table 46 or rack 47 need only hold supply component 9S and device 9F, and hence, wheeled table 46 and rack 47 can take various forms. As shown in Fig. 3a, in the present embodiment, first delivery section 43a and second delivery section 43b are formed into rack 47 which includes multiple storage spaces.

For example, first storage section 43a is formed in an upper space of rack 47, while second delivery section 43b is formed in a lower space of rack 47. A door portion is provided in second opening section 41b shown in Fig. 3b. The upper space and the lower space of rack 47 can communicate with delivery space 40f via second opening section 41b. Specifically speaking, the door portion is caused to be in an open state by control device 40a when supply component 9S and device 9F are delivered out. Then, supply component 9S and device 9F which are used for identical unit production UJ0 are delivered out in an associated fashion by way of second opening section 41b. When supply component 9S and device 9F are so delivered out, the door portion is caused to be in a closed state by control device 40a.

Control device 40a includes a known arithmetic unit and a storage device, as well as a control circuit which is configured therein. Control device 40a is provided so as to be capable of communicating with moving device 40b, acquisition device 40d, and display device 40e and can control these devices. In addition, control device 40a can also cause a door portion provided in first opening section 41a and the door portion provided in second opening section 41b to be opened and closed. Further, control device 40a can store supply information on supply component 9S and can also notify management device 19 of the supply component information.

For example, in the case that supply component 9S is reel 91a, the supply information can include a type of a component accommodated in reel 91a, the number of components (the number of remaining components), a reel diameter, a reel model type, and a reel supplier (vendor), an expiration date, and the like. Similarly, control device 40a can store device information on device 9F and can also notify management device 19 of the device information. For example, in the case that device 9F is mounting head 95a, the device information can include the number of times of use of mounting head 95a, the duration of use of mounting head 95a, component mounter 10c which uses mounting head 95a, the maintenance time of mounting head 95a, and the like.

When supply component 9S is received in storage cabinet 40 via first opening section 41a, moving device 40b moves supply component 9S so received to predetermined first storage section 42a, and when supply component 9S is delivered out, moving device 40b moves supply component 9S stored in first storage section 42a to delivery space 40f. Similarly, when device 9F is received in storage cabinet 40 via firs opening section 41a, moving device 40b moves device 9F so received to predetermined second storage section 42b, and when device 9F is delivered out, moving device 40b moves device 9F stored in second storage section 42b to delivery space 40f.

The same applies when accommodation case 93 which accommodates at least one of supply component 9S and device 9F is received in storage cabinet 40 by way of first opening section 41a. That is, when accommodation case 93 is received in by way of first opening section 41a, moving device 40b moves accommodation case 93 so received to predetermined first storage section 42a, second storage section 42b or third storage section 42c. In addition, when accommodation case 93 is delivered out, moving device 40b moves accommodation case 93 stored in first storage section 42a, second storage section 42b or third storage section 42c to delivery space 40f.

As shown in Fig. 3b, moving device 40b of the present embodiment is provided radially inwards of storage section 42 as viewed in the vertical direction (the Z-axis direction). Moving device 40b need only be able to move a target object (supply component 9S and device 9F or accommodation case 93) and hence can take various forms. For example, a robot arm (an articulated robot), a lifting and lowering slide mechanism, and the like can be used for moving device 40b.

Moving device 40b can include, for example, a raising/lowering section 40b1 and gripping section 40b2. Raising/lowering section 40b1 can rotate around an axis extending along the vertical direction (the Z-axis direction) and can raise or lower gripping section 40b2 along the vertical direction (the Z-axis direction). Gripping section 40b2 can advance or retreat and can hold or release a hold of a target object. As a result, moving device 40b can store a target object that is received in by way of first opening section 41a in storage section 42 and can move the target object to delivery space 40f. In addition, moving device 40b can also move the target object moved to delivery space 40f to delivery section 43. Further, moving device 40b can include a conveyance device (that is, a belt conveyor or the like) in delivery space 40f. In this case, the conveyance device can move the target object moved to delivery space 40f to delivery section 43.

When delivering supply component 9s, moving device 40b can also move supply component 9S stored in first storage section 42a to work space 40c provided in first opening section 41a. Similarly, when delivering device 9F, moving device 40b can move device 9F stored in second storage section 42b to work space 40c provided in first opening section 41a. In addition, when delivering both supply component 9S and device 9F, moving device 40b can move supply component 9S and device 9F which are stored in third storage section 42c to work space 40c provided in first opening section 41a. What is described above applies to a case in which at least one of supply component 9S and device 9F is accommodated in accommodation case 93.

With storage cabinet 40 of the present embodiment, at least one of supply component 9S and device 9F is stored while being accommodated in accommodation case 93 and is delivered out while being accommodated in accommodation case 93. As a result, at least one of supply component 9S and device 9F which is accommodated in accommodation case 93 can easily be moved, and hence, irrespective of types of supply component 9S and device 9F, gripping section 40b2 of moving device 40b can easily be shared with. In addition, at least one of supply component 9S and device 9F can easily be managed to thereby reduce a risk of being lost or the like by storing and delivering at least one of supply component 9S and device 9F while being accommodated in accommodation case 93.

As has been described above, accommodation case 93 can accommodate various types of supply components 9S and can accommodate various types of devices 9F. In addition, accommodation case 93 accommodates both supply component 9S and device 9F (can accommodate device 9F and supply component 9S together). For example, let's assume a case in which board work machine 10 is component mount 10c for mounting a component, which is supply component 9S, on board 90, which is supply component 9S. In this case, for example, since there exists a case in which the use of holding member 95c for holding a component is limited depending on a type of component, there may be a case in which a component and holding member 95c for holding the component are preferably managed together. In this case, holding member 95c, which is device 9F for picking up to hold a component and mounting the component on board 90, and a component which can be held by holding member 95c need only be accommodated together in accommodation case 93. In this way, device 9F and supply component 9S need only be accommodated together in accommodation case 93 as the degree at which supply component 9S and device 9F are related to each other (the degree of association) becomes higher.

As shown in Fig. 3a, storage cabinet 40 includes display device 40e. A know display device can be used for display device 40e, and this display device 40e displays various types of data in such a way that the operator can visually recognize them. Display device 40e displays, for example, supply component information on supply component 9S stored in first storage section 42a, device information on device 9F stored in second storage section 42b, and the like in response to an operation by the operator.

In addition, control device 40a can store positional information, receiving and delivery information and storage information on supply component 9S and device 9F in storage section 42, and display device 40e can also display these pieces of information. The positional information indicates storage locations of supply component 9S and device 9F. The receiving and delivery information indicates receiving date and time and delivery date and time of each of supply component 9S and device 9F. The storage information includes, for example, information on the ambient temperature in storage section 42, the humidity in storage section 42, and the like. Control device 40a stores positional information and receiving date and time of each of supply component 9S and device 9F when that supply component 9S and that device 9F are received to be stored. Control device 40a stores storage information on supply component 9S and device 9F while that supply component 9S and that device 9F are being stored. Control device 40a stores delivery date and time of each of supply component 9S and device 9F when that supply component 9S and that device 9F are delivered out.

Display device 40e of the present embodiment is made up of a touch panel, and display device 40e also functions as an input device for receiving various types of operations by the operator. For example, the operator can also specify supply component 9S and device 9F which are desired to be delivered out from storage cabinet 40 by use of the touch panel (display device 40e functioning as the input device). In this case, storage cabinet 40 delivers out supply component 9S and device 9F which are so specified.

1-3-2. Control Example of Supply Component 9S and Device 9F for Receiving and Delivery

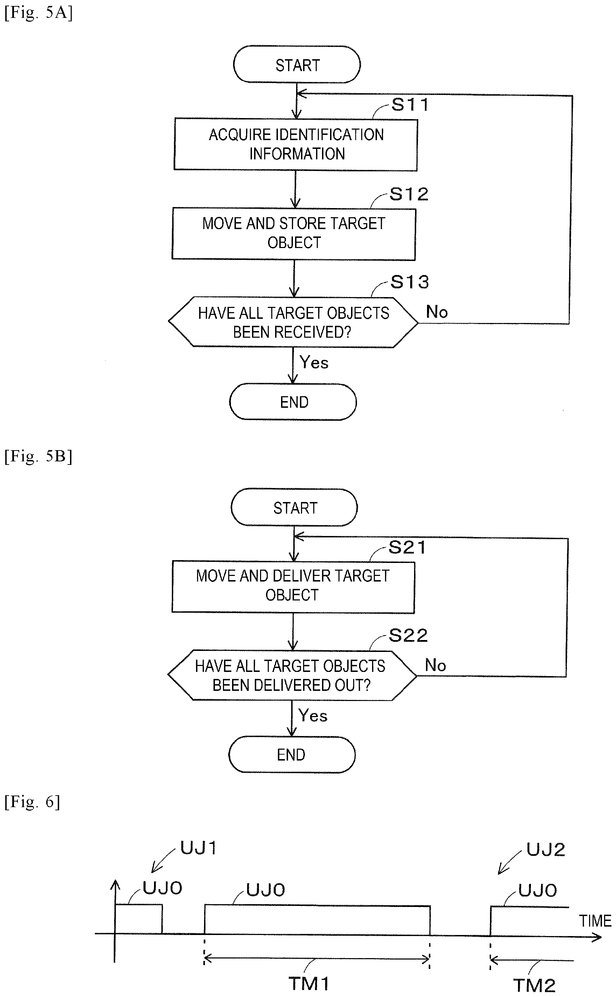

As shown in Fig. 4, when taken as control blocks, control device 40a includes moving section 44 and guide section 45. Control device 40a executes control programs in accordance with flowcharts shown in Figs. 5a and 5b.

Fig. 5a shows an example of a control procedure for a receiving operation of supply component 9S and device 9F. Control device 40a acquires identification information of supply component 9S using acquisition device 40d when supply component 9S is received in via first opening section 41a (Step S11). Similarly, control device 40a can also acquire identification information of device 9F using acquisition device 40d when device 9F is received in via first opening section 41a.

In addition, control device 40a can also acquire specific information of accommodation case 93 using acquisition device 40d when accommodation case 93 is received in via first opening section 41a. In this case, control device 40a acquires the identification information of at least one of supply component 9S and device 9F which is accommodated in accommodation case 93 based on the correspondence between the specific information and the identification information. In any of the cases, control device 40a causes the storage device to store the acquired identification information.

Next, moving section 44 causes moving device 40b to move supply component 9S to predetermined first storage section 42a for storage therein (Step S12). Similarly, moving section 44 can also cause moving device 40b to move device 9F to predetermined second storage section 42b for storage therein. In addition, moving section 44 can also cause moving device 40b to move supply component 9S and device 9F to predetermined third storage section 42c for storage therein. Further, moving section 44 can also cause moving device 40b to move accommodation case 93 to predetermined storage section 42 for storage therein. In any of the cases, control device 40a causes the storage device to store the positional information and the receiving dates and times of supply component 9S and device 9F.

Next, control device 40a determines whether all supply components 9S and devices 9F that are scheduled to be received in storage cabinet 40 have been so received (step S13). If all supply components 9S and devices 9F that are scheduled to be received in storage cabinet 40 have been so received (if Yes in Step S13), control device 40a ends temporarily the control for the receiving operation. If all supply components 9S and devices 9F that are scheduled to be received in storage cabinet 40 have not yet been so received (if NO in Step S13), control device 40a returns to the operation in Step S 11 for the receiving operation. Then, control device 40a repeats the operations shown in Steps S11 to S13 until all supply components 9S and devices 9F that are scheduled to be received in storage cabinet 40 have been so received.

Fig. 5b shows an example of a control procedure for a delivery operation of supply component 9S and device 9F. The production plan is managed by, for example, management device 19, and management device 19 transmits a delivery command of delivering supply component 9S and device 9F which are to be used for identical unit production UJ0 to storage cabinet 40 based on the production plan. When receiving the delivery command, storage cabinet 40 associates supply component 9S and device 9F with each other for use for specified identical unit production UJ0 and then delivers that supply component 9S and that device 9F which are so associated with each other.

Specifically speaking, moving section 44 moves supply component 9S stored in first storage section 42 to delivery section 43 and moves device 9F stored in second storage section 42b to delivery section 43. In addition, moving section 44 can also move supply component 9S stored in first storage section 42a to first delivery section 43a and move device 9F stored in second storage section 42b to second delivery section 43b. In the present embodiment, moving section 44 causes moving device 40b to move supply component 9S stored in first storage section 42a to delivery space 40f and then to move that supply component 9S moved to delivery space 40f to first delivery section 43a.

In addition, moving section 44 causes moving device 40b to move device 9F stored in second storage section 42b to delivery space 40f and then to move that device 9F moved to delivery space 40f to second delivery section 43b (step S21). Moving section 44 can also cause moving device 40b to move accommodation case 93 stored in storage section 42 to delivery space 40f and then to move that accommodation case 93 moved to delivery space 40f to delivery section 43. In any of the cases, control device 40a causes the storage device to store the delivery dates and times of supply component 9S and device 9F.

Next, control device 40a determines whether all supply components 9S and devices 9F that are scheduled to be delivered out from storage cabinet 40 have been so delivered out (Step S22). If control device 40a determines that all supply components 9S and devices 9F that are scheduled to be delivered out from storage cabinet 40 have been so delivered out (Yes in Step S22), control device 40a ends temporarily the control for delivery operation. If control device 40a determines that all supply components 9S and devices 9F that are scheduled to be delivered out from storage cabinet 40 have not yet been so delivered out (No in Step S22), control device 40a returns to the operation in Step S21. Then, control device 40a repeats the operations shown in Steps S21 and S22 until all supply components 9S and devices 9F that are scheduled to be delivered out from storage cabinet 40 have been so delivered out.

Here, one unit production UJ0 in which board products 900 are produced by board work machine 10 is referred to as first unit production UJ1. In addition, as shown in Fig. 6, at least one unit production UJ0 which is carried out after first unit production UJ1 on is referred to as second unit production UJ2. In first unit production UJ1, since board products 900 are produced by board work machine 10, device 9F has already been mounted in board work machine 10. Therefore, there are fewer delivery requests for device 9F in first unit production UJ1 than in second unit production UJ2.

Then, as a mode in which delivery section 43 delivers out supply component 9S and device 9F in an associated fashion, a case is assumed in which supply component 9S and device 9F are delivered out for use for second unit production UJ2. In this case, moving section 44 can move supply component 9S and device 9F which are used for second unit production UJ2. Specifically speaking, moving section 44 causes moving device 40b to move supply component 9S and device 9F which are used for second production UJ2 based on a delivery command received from management device 19.

Storage cabinet 40 of the present embodiment includes guide section 45. Guide section 45 notifies the operator of first delivery section 43a from which supply component 9S for use for second unit production UJ2 is delivered out and second delivery section 43b from which device 9F for use for second unit production UJ2 is delivered out. As a result, the operator can easily recognize supply component 9S and device 9F which are used for second unit production UJ2.

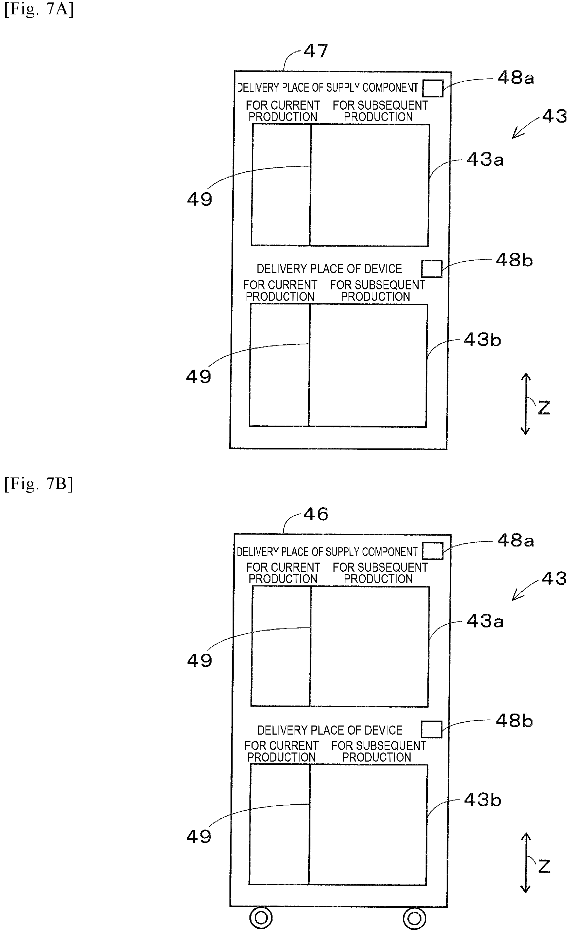

Guide section 45 need only notify the operator of first delivery section 43a and second delivery section 43b, and hence, guide section 45 can take various forms. For example, guide section 45 can display the positions of those first delivery section 43a and second delivery section 43b which are formed into rack 47 by use of display device 40e shown in Fig. 3a. In addition, as shown in Fig. 7a, guide section 45 can also display the positions of those first delivery section 43a and second delivery section 43b which are formed into rack 47 by use of a display device which is provided on rack 47.

Specifically speaking, guide section 45 displays an indicator in the vicinity of the upper space of rack 47 indicating that the upper space is a delivery location for supply component 9S, whereby guide section 45 notifies that that first delivery section 43a is formed in the upper space of rack 47. Similarly, guide section 45 displays an indicator in the vicinity of the lower space of rack 47 indicating that the lower space is a delivery location for device 9F, whereby guide section 45 notifies that that second delivery section 43b is formed in the lower space of rack 47.

In first unit production UJ1, since board products 900 are produced by board work machine 10, there is a possibility of, for example, occurrence of a shortage of components accommodated in reel 91a (a shortage of supply components 9S). In the case that a shortage of supply components 9S occurs, or in the case that there is a possibility of a shortage of supply components 9S, management device 19 transmits a delivery command of delivering supply components 9S required to storage cabinet 40. Upon receipt of the delivery command, storage cabinet 40 delivers out supply components 9S so required.

In this case, moving section 44 causes moving device 40b to move supply component 9S which is used for first unit production UJ1 to first delivery section 43a. Specifically speaking, moving section 44 causes moving device 40b to move supply component 9S which is used for first unit production UJ1 to first delivery section 43a based on a delivery command received from management device 19. In this case, guide section 45 need only notify of first delivery section 43a from which supply component 9S which is used for first unit production UJ1 is delivered out and first delivery section 43a from which supply component 9S which is used for second unit production UJ2 is delivered out in a distinguishable fashion.

Specifically speaking, guide section 45 can notify through display that a part of the upper space of rack 47 shown in Fig. 7a is allocated for the current production to thereby notify the operator that supply component S9 which is used for first unit production UJ1 is delivered to the space so allocated. In addition, guide section 45 can notify through display that the remainder of the upper space of rack 47 shown in Fig. 7a is allocated for a subsequent production to thereby notify the operator that supply component 9S which is used for second unit production UJ2 is delivered to the space so allocated. As a result, the operator can identify to distinguish first delivery section 43a from which supply component 9S which is used for first unit production UJ1 is delivered out from first delivery section 43a from which supply component 9S which is used for second unit production UJ2 is delivered out.

As has been described above, although there are fewer delivery requests for device 9F in first unit production UJ1 than in second unit production UJ2, there is also a possibility of occurrence of a necessity of new device 9F in first unit production UJ1 due to, for example, a failure of device 9F currently in use. Therefore, as in the case with supply component 9S, moving section 44 can also causes moving device 40b to move device 9F which is used for first unit production UJ1 to second delivery section 43b. In this case, guide section 45 need only notify the operator of second delivery section 43b from which device 9F which is used for first unit production UJ1 is delivered out and second delivery section 43b from which device 9F which is used for second unit production UJ2 is delivered out in a distinguishable fashion.

Specifically speaking, guide section 45 can notify through display that a portion of the lower space of rack 47 shown in Fig. 7a is allocated for the current production to thereby notify the operator that device 9F which is used for first unit production UJ1 is delivered to the space so allocated. In addition, guide section 45 can notify through display that the remainder of the lower space of rack 47 shown in Fig. 7a is allocated for a subsequent production to thereby notify the operator that device 9F which is used for second unit production UJ2 is delivered to the space so allocated. As a result, the operator can identify to distinguish second delivery section 43b from which device 9F which is used for first unit production UJ1 is delivered out from second delivery section 43b from which device 9F which is used for second unit production UJ2 is delivered out.

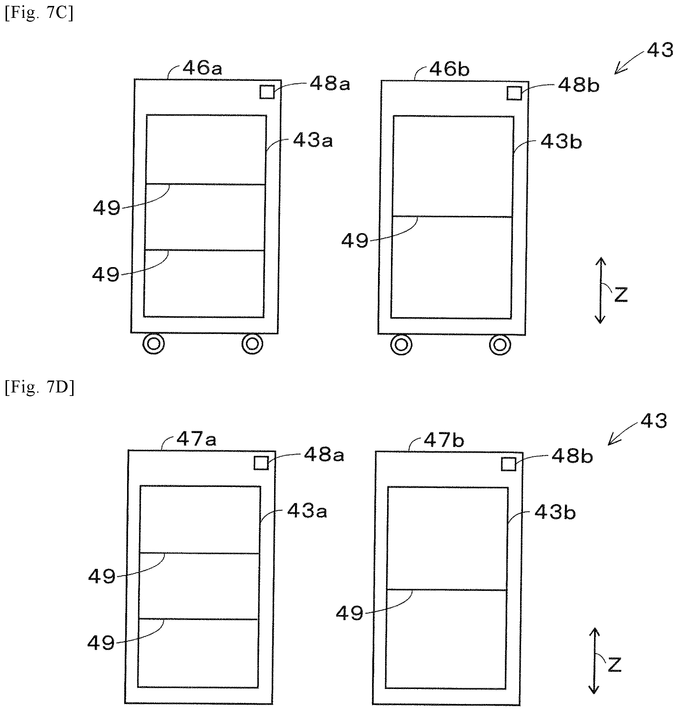

In addition, partition plate 49 can be provided in rack 47. Partition plate 49 provided in first delivery section 43a shown in Fig. 7a divides first delivery section 43a into first delivery section 43a from which supply component 9S which is used for first unit production UJ1 is delivered out and first delivery section 43a from which supply component 9S which is used for second unit production UJ2 is delivered out. In addition, partition plate 49 provided in second delivery section 43b divides second delivery section 43b into second delivery section 43b from which device 9F which is used for first unit production UJ1 is delivered out and second delivery section 43b from which device 9F which is used for second unit production UJ2 is delivered out. What is described about guide section 45 similarly applies wheeled table 46 shown in Fig. 7b and also similarly applies to forms shown in Figs. 7c and 7d.

There may be a case in which the operator has difficulty in distinguishing supply component 9S which is used for last unit production UJ0 from supply component 9S which is used for unit production UJ0 which is carried out after the last unit production UJ0 on. Then, guide section 45 need only notify the operator of first delivery section 43a from which supply component 9S which is used for unit production UJ0 occurring subsequent to first unit production UJ1 is delivered out and first delivery section 43a from which supply component 9S which is used for unit production UJ0 occurring subsequent to unit production UJ0 occurring subsequent to first unit production UJ1 is delivered out in a distinguishable fashion.

Specifically speaking, guide section 45 notifies through display that the remainder of the upper space of rack 47 shown in Fig. 7a is allocated for a subsequent production and a production after the subsequent production on instead of notifying that the remainder of the upper space of rack 47 is allocated for the subsequent production. As a result, the operator can identify to distinguish first delivery section 43a from which supply component 9S which is used for unit production UJ0 subsequent to first unit production UJ1 is delivered out from first delivery section 43a from which supply component 9S which is used for unit production UJ0 occurring subsequent to unit production UJ0 occurring subsequent to first unit production UJ1 is delivered out. Partition plate 49 can also be provided in each of these first delivery sections 43a.

What is described on supply component 9S similarly applies to device 9F. Then, guide section 45 need only notify the operator of second delivery section 43b from which device 9F which is used for unit production UJ0 occurring subsequent to first unit production UJ1 is delivered out and second delivery section 43b from which device 9F which is used for unit production UJ0 occurring subsequent to unit production UJ0 occurring subsequent to first unit production UJ1 is delivered out in a distinguishable fashion.

Specifically speaking, guide section 45 notifies through display that the remainder of the lower space of rack 47 shown in Fig. 7a is allocated for a subsequent production and a production after the subsequent production on instead of notifying that the remainder of the lower space of rack 47 is allocated for the subsequent production. As a result, the operator can identify to distinguish second delivery section 43b from which device 9F which is used for unit production UJ0 subsequent to first unit production UJ1 is delivered out from second delivery section 43b from which device 9F which is used for unit production UJ0 occurring subsequent to unit production UJ0 occurring subsequent to first unit production UJ1 is delivered out. Partition plate 49 can also be provided in each of these second delivery sections 43b.

In addition, there may be a case in which the operator wants to identify to distinguish supply component 9S which is used for a predetermined production time slot (for example, a morning production for board products 900) from supply component 9S which is used for a production time slot (for example, an afternoon production for board products 900) occurring after the predetermined production time slot. Then, guide section 45 need only notify of first delivery section 43a from which supply component 9S which is used for first production time slot TM1 is delivered out and first delivery section 43a from which supply component 9S which is used for second production time slot TM2 is delivered out in a distinguishable fashion. In first production time slot TM1, at least one unit production UJ0 of second unit production UJ2 is performed. As shown in Fig. 6, second production time slot TM2 occurs later than first production time slot TM1, and in second production time slot TM2, at least one unit production UJ0 of the other unit productions UJ0 of second unit production UJ2 is performed.

In this mode, guide section 45 notifies that the remainder of the upper space of rack 47 shown in Fig. 7a is allocated for a production in first production time slot TM1 and a production in second production time slot TM2 instead of notifying that the remainder of the upper space of rack 47 is allocated for a subsequent production. As a result, the operator can identify to distinguish first delivery section 43a from which supply component 9S which is used for first production time slot TM1 is delivered out from first delivery section 43a from which supply component 9S which is used for second production time slot TM2 is delivered out. Partition plate 49 can also be provided in each of these first delivery sections 43a.

What is described on supply component 9S similarly applies to device 9F. Then, guide section 45 need only notify of second delivery section 43b from which device 9F which is used for first production time slot TM1 is delivered out and second delivery section 43b from which device 9F which is used for second production time slot TM2 is delivered out in a distinguishable fashion.

In this mode, guide section 45 notifies that the remainder of the lower space of rack 47 shown in Fig. 7a is allocated for a production in first production time slot TM1 and a production in second production time slot TM2 instead of notifying that the remainder of the lower space of rack 47 is allocated for a subsequent production. As a result, the operator can identify to distinguish second delivery section 43b from which device 9F which is used for first production time slot TM1 is delivered out from second delivery section 43b from which device 9F which is used for second production time slot TM2 is delivered out. Partition plate 49 can also be provided in each of these second delivery sections 43b.

In the present embodiment, first delivery section 43a and second delivery section 43b are formed into rack 47 which can hold supply component 9S and device 9F. For example, first delivery section 43a and second delivery section 43b can be formed into wheeled table 46 which can hold supply component 9S and device 9F. As shown in Fig. 7b, wheeled table 46 includes a similar configuration to that of rack 47 described above. In addition, wheeled table 46 can adopt, for example, a conveyance vehicle similar to conveyance vehicle 30, which may be an unmanned conveyance vehicle or may be pulled by the operator.

First delivery section 43a and second delivery section 43b can also be formed into multiple wheeled tables 46 or multiple racks 47. In addition, in one wheeled table 46 or one rack 47, multiple first delivery sections 43a may be formed, or multiple second delivery sections 43b may be formed, respectively. In either of the cases, first delivery section 43a needs to be identified, and second delivery section 43b needs to be identified. Then,first identification section 48a for identifying first delivery section 43a and second identification section 48b for identifying second delivery section 43b need only be provided on wheeled table 46 or rack 47.

First identification section 48a need only identify first delivery section 43a and hence can take various forms. Similarly, second identification section 48b need only identify second delivery section 43b and hence can take various forms. First identification section 48a and second identification section 48b can each adopt, for example, a one-dimensional code, a two-dimensional code, a wireless tag, or the like. First identification section 48a and second identification section 48b may be a form of notification by guide section 45.

In addition, as shown in Fig. 7c, first delivery section 43a may be formed into first wheeled table 46a which can hold supply component 9S, and second delivery section 43b may be formed into second wheeled table 46b which can hold device 9F. In this case, first identification section 48a for identifying first delivery section 43a need only be provided on first wheeled table 46a, and second identification section 48b for identifying second delivery section 43b need only be provided on second wheeled table 46b.

Further, as shown in Fig. 7d, first delivery section 43a may be formed into first rack 47a which can hold supply component 9S, and second delivery section 43b may be formed into second rack 47b which can hold device 9F. In this case, first identification section 48a for identifying first delivery section 43a need only be provided on first rack 47a, and second identification section 48b for identifying second delivery section 43b need only be provided on second rack 47b. In either of the cases, storage cabinet 40 and the operator can identify first delivery section 43a and can identify second delivery section 43b.

### 1-4. Others

With storage cabinet 40 of the embodiment, supply component 9S and device 9F are delivered out while being associated with each other by way of second opening section 41b. However, with storage cabinet 40, supply component 9S and device 9F can also be delivered out while being associated with each other by way of first opening section 41a. For example, moving section 44 can cause moving device 40b to deliver out accommodation case 93 which accommodates supply component 9S and device 9F by way of first opening section 41a. In addition, a conveyance device can also be provided outside storage cabinet 40. In this case, the conveyance device conveys supply component 9S delivered out by way of first opening section 41a to delivery section 43. The conveyance device conveys device 9F delivered out by way of first opening section 41a to delivery section 43. In addition, the conveyance device can convey supply component 9S delivered out by way of first opening section 41a to first delivery section 43a. The conveyance device can convey device 9F delivered out by way of first opening section 41a to second delivery section 43b. In addition, the conveyance device can convey accommodation case 93, accommodating at least one of supply component 9S and device 9F, which is delivered out by way of first opening section 41a to delivery section 43.

In addition, delivery section 43 is not limited to the form in which the exclusive delivery sections are defined as with first delivery section 43a and second delivery section 43b. Delivery section 43 may take, for example, a form in which a location corresponding to first delivery section 43a and a location corresponding to second delivery section 43b are mixed together. In this case, storage cabinet 40 may adopt a configuration in which delivery section 43 is divided for each identical unit production UJ0 and supply component 9S and device 9F which are used for identical unit production UJ0 are delivered individually to the divided sections. In addition, delivery section 43 may be configured so that only supply component 9S and device 9F which are used for one unit production UJ0 are delivered out, while supply component 9S and device 9F which are used for another unit production UJ0 are not delivered out at the same time.

### 2. Examples of Advantages of Embodiment

With storage cabinet 40, storage cabinet 40 includes first storage section 42a, second storage section 42b, delivery section 43, and moving section 44. As a result, with storage cabinet 40, supply component 9S can be stored in first storage section 42, and device 9F can be stored in second storage section 42b. In addition, with storage cabinet 40, moving section 44 causes supply component 9S stored in first storage section 42a to be delivered to delivery section 43 and causes device 9F stored in second storage section 42b to be delivered to delivery section 43, and delivery section 43 can deliver out supply component 9S and device 9F which are used for predetermined unit projection UJ0 therefrom in an associated fashion.

### Reference Signs List

10: board work machine, 10c: component mounter, 40: storage cabinet, 42a: first storage section, 42b: second storage section, 43: delivery section, 43a: first delivery section, 43b: second delivery section, 44: moving section, 45: guide section, 46: wheeled table, 46a: first wheeled table, 46b: second wheeled table, 47: rack, 47a: first rack, 47b: second rack, 48a: first identification section, 48b: second identification section, 90: board, 91: article, 93: accommodation case, 95c: holding member, 9S: supply component, 9F: device, 900: board product, UJ0: unit production, UJ1: first unit production, UJ2: second unit production, TM1: first production time slot, TM2: second production time slot

## Claims

1. A storage cabinet (40) comprising:
a first storage section (42a) configured to store a supply component (9S) which is at least one of an article (91) which is provided on a board (90) by a board work machine (10) configured to perform predetermined board work on the board (90) and the board (90) before the article (91) is provided thereon;
a second storage section (43a) configured to store a device (9F) which is detachably provided on the board work machine (10) for use in the board work;
a delivery section (43) configured to deliver the supply component (9S) and the device (9F) in an associated fashion which are used for a predetermined unit production (UJO) included in a production plan which prescribes an order of unit productions (UJO) which each specify a production of an identical type of board products (900) using the board work machine (10); and
a moving section (44) configured to move the supply component (9S) stored in the first storage section (42a) to the delivery section (43) and moves the device (9F) stored in the second storage section (43a) to the delivery section,
wherein the device (9F) and the supply component (9S) are accommodated together in an accommodation case (93).

2. The storage cabinet (40) according to claim 1,
wherein the board work machine (10) is a component mounter (10c) configured to mount a component, which is the supply component, on the board (90), which is the supply component, and
wherein a holding member (95c), which is the device and is configured to pick up, hold, and mount the component on the board (90), and the component, which can be held by the holding member (95c), are accommodated together in the accommodation case.

3. The storage cabinet (40) according any one of claims 1 to 2,
wherein the moving section (44) is configured to move the supply component (9S) and the device (9F) which are used for a second unit projection which is at least one of the unit productions (UJO) occurring subsequent to a first unit production (UJ1) which is one of the unit productions (UJO) in which the board products (900) are produced by the board work machine (10).

4. The storage cabinet (40) according to claim 3,
wherein the delivery section (43) comprises:
a first delivery section(43) from which the supply component (9S) which is used for the unit production (UJO) is delivered out; and
a second delivery section (43) from which the device (9F) which is used for the unit production is delivered out, the unit production (UJO) being identical to the unit production (UJO) in which the supply component (9S) is used.

5. The storage cabinet (40) according to claim 4, further comprising:
a guide section (45) configured to notify an operator of the first delivery section (43a) from which the supply component (9S) which is used for the second unit production (UJ2) is delivered out and the second delivery section (43b) from which the device (9F) which is used for the second unit production (UJ2) is delivered out.

6. The storage cabinet (40) according to claim 5,
wherein the guide section (45) notifies of the first delivery section (43a) from which the supply component (9S) which is used for the unit production (UJO) subsequent to the first unit production (UJ1) is delivered out and the first delivery section (43a) from which the supply component (9S) which is used for the unit production (UJO) occurring subsequent to the unit production occurring subsequent to the first unit production (UJ1) is delivered out in a distinguishable fashion.

7. The storage cabinet (40) according to claim 5 or 6,
wherein the guide section (45) notifies of the second delivery section (43b) from which the device (9F) which is used for the unit production (UJO) subsequent to the first unit production (UJ1) is delivered out and the second delivery section (43b) from which the device (9F) which is used for the unit production o(UJ0) ccurring subsequent to the unit production occurring subsequent to the first unit production (UJ1) is delivered out in a distinguishable fashion.

8. The storage cabinet (40) according to claim 5,
wherein the guide section (45) notifies of the first delivery section (43a) from which the supply component (9S) which is used for a first production time slot (TM1), in which at least one of the unit productions (UJO) of the second unit production (UJ2) is performed, is delivered out and the first delivery section (43a) from which the supply component (9S) which is used for a second production time slot (TM2), which occurs later than the first production time slot (TM1)and in which at least one unit production (UJO) of the other unit productions (UJO) of the second unit production (UJ2) is performed, is delivered out in a distinguishable fashion.

9. The storage cabinet (40) as claimed in claim 5 or claim 6,
wherein the guide section (45) notifies of the second delivery section (43b) from which the device (9F) which is used for a first production time slot (TM1), in which at least one of the unit productions (UJO) of the second unit production (UJ2) is performed, is delivered out and the second delivery section (43b) from which the device (9F) which is used for a second production time slot (TM2), which occurs later than the first production time slot (TM1)and in which at least one unit production (UJO) of the other unit productions (UJO) of the second unit production (UJ2) is performed, is delivered out in a distinguishable fashion.

10. The storage cabinet (40) according to any one of claims 5 to 9,
wherein the moving section (44) moves the supply component (9S) which is used for the first unit production (UJO) to the first delivery section, and
wherein the guide section (45) notifies of the first delivery section (43a) from which the supply component (9S) which is used for the first unit production (UJ1) is delivered out and the first delivery section (43a) from which the supply component (9S) which is used for the second unit production (UJ2) is delivered out in a distinguishable fashion.

11. The storage cabinet (40) according to any one of claims 1 to 10,
wherein the delivery section comprises:
a first delivery section (43a) from which the supply component (9S) which is used for the unit production (UJO) is delivered out; and
a second delivery section (43b) from which the device (9F) which is used for the unit production (UJO) identical to the unit production (UJO) for which the supply component delivered out from the first delivery section (43a) is used is delivered out,
wherein the first delivery section (43a) and the second delivery section (43b) are formed into a wheeled table (46) or a rack which can hold the supply component (9S) and the device (9F), and
wherein a first identification section (48a) configured to identify the first delivery section (43a) and a second identification section (48b) configured to identify the second delivery section (43b) are provided on the wheeled table (46) or the rack (46).

12. The storage cabinet (40) according to any one of claims 1 to 10,
wherein the delivery section (43) comprises:
a first delivery section (43a) from which the supply component (9S) which is used for the unit production (UJO) is delivered out; and
a second delivery section (43b) from which the device (9F) which is used for the unit production (UJO) identical to the unit production (UJO) for which the supply component (9S) delivered out from the first delivery section (43a) is used is delivered out,
wherein the first delivery section (43a) is formed into a first wheeled table (46a) or a first rack (46a) which can hold the supply component (9S),
wherein the second delivery section (43b) is formed into a second wheeled table (46b) or a second rack (46b) which can hold the device (9F),
wherein a first identification section (48a) configured to identify the first delivery section(43a) is provided on the first wheeled table (46a) or the first rack (46a), and
wherein a second identification section (48b) configured to identify the second delivery section (43b) is provided on the second wheeled table (46b) or the second rack (46b).

## Patentansprüche

1. Ein Lagerschrank (40), der Folgendes umfasst:
einen ersten Speicherabschnitt (42a), der so konfiguriert ist, dass er eine Zulieferungskomponente (9S) speichert, die mindestens ein Artikel (91) ist, der auf einer Platte (90) durch eine Plattenbearbeitungsmaschine (10) bereitgestellt wird, die so konfiguriert ist, dass sie eine vorbestimmte Plattenbearbeitung an der Platte (90) und der Platte (90) durchführt, bevor der Artikel (91) darauf bereitgestellt wird;
einen zweiten Aufbewahrungsabschnitt (43a), der so konfiguriert ist, dass er eine Vorrichtung (9F) aufnimmt, die abnehmbar an der Plattenbearbeitungsmaschine (10) zur Verwendung bei der Plattenbearbeitung vorgesehen ist;
einen Lieferabschnitt (43), der so konfiguriert ist, dass er die Zulieferungskomponente (9S) und die Vorrichtung (9F) in einer zugeordneten Weise liefert, die für eine vorbestimmte Einheitsproduktion (UJO) verwendet werden, die in einem Produktionsplan enthalten ist, der eine Reihenfolge von Einheitsproduktionen (UJO) vorschreibt, die jeweils eine Produktion eines identischen Typs von Plattenprodukten (900) unter Verwendung der Plattenbearbeitungsmaschine (10) spezifizieren; und
einen Bewegungsabschnitt (44), der so konfiguriert ist, dass er die in dem ersten Lagerabschnitt (42a) gelagerte Zulieferungskomponente (9S) zu dem Lieferabschnitt (43) bewegt und die in dem zweiten Lagerabschnitt (43a) gelagerte Vorrichtung (9F) zu dem Lieferabschnitt bewegt,
wobei die Vorrichtung (9F) und die Zulieferungskomponente (9S) zusammen in einem Unterbringungsgehäuse (93) untergebracht sind.

2. Der Lagerschrank (40) nach Anspruch 1,
wobei die Leiterplattenbearbeitungsmaschine (10) eine Bauteilmontagevorrichtung (10c) ist, die so konfiguriert ist, dass sie ein Bauteil, das die Zulieferungskomponente ist, auf der Platte (90) montiert, und
wobei ein Halteelement (95c), bei dem es sich um die Vorrichtung handelt und das zum Aufnehmen, Halten und Montieren des Bauteils auf der Platte (90) konfiguriert ist, und das Bauteil, das von dem Halteelement (95c) gehalten werden kann, zusammen in dem Aufnahmegehäuse untergebracht sind.

3. Der Lagerschrank (40) nach einem der Ansprüche 1 bis 2,
wobei der Bewegungsabschnitt (44) konfiguriert ist, um die Zulieferungskomponente (9S) und die Vorrichtung (9F) zu bewegen, die für eine zweite Einheitsproduktion verwendet werden, die mindestens eine der Einheitsproduktionen (UJO) ist, die im Anschluss an eine erste Einheitsproduktion (UJ1) auftritt, die eine der Einheitsproduktionen (UJO) ist, bei der die Plattenprodukte (900) durch die Plattenbearbeitungsmaschine (10) hergestellt werden.

4. Der Lagerschrank (40) nach Anspruch 3,
wobei der Lieferabschnitt (43) umfasst:
einen ersten Lieferabschnitt (43), aus dem die für die Stückproduktion (UJO) verwendete Zulieferkomponente (9S) ausgeliefert wird; und
einen zweiten Lieferabschnitt (43), aus der die Vorrichtung (9F), die für die Einheitsproduktion verwendet wird, ausgegeben wird, wobei die Einheitsproduktion (UJO) identisch ist mit der Einheitsproduktion (UJ0), in der die Zulieferungskomponente (9S) verwendet wird.

5. Der Lagerschrank (40) nach Anspruch 4, ferner umfassend:
einen Führungsabschnitt (45), der so konfiguriert ist, dass er einen Bediener des ersten Lieferabschnitts (43a), aus dem die für die zweite Einheitsproduktion (UJ2) verwendete Zulieferungskomponente (9S) abgegeben wird, und des zweiten Lieferabschnitts (43b), aus dem die für die zweite Einheitsproduktion (UJ2) verwendete Vorrichtung (9F) abgegeben wird, informiert.

6. Der Lagerschrank (40) nach Anspruch 5,
wobei der Führungsabschnitt (45) einem Bediener den ersten Lieferabschnitt (43a), aus dem die für die auf die erste Einheitsproduktion (UJ1) folgende Einheitsproduktion (UJO) verwendete Zulieferungskomponente (9S) abgegeben wird, und den ersten Lieferabschnitt (43a), aus dem die für die auf die auf die erste Einheitsproduktion (UJ1) folgende Einheitsproduktion (UJO) verwendete Zulieferungskomponente (9S) abgegeben wird, unterscheidbar meldet.

7. Der Lagerschrank (40) nach Anspruch 5 oder 6,
wobei der Führungsabschnitt (45) einem Bediener den zweiten Lieferabschnitt (43b), von dem aus die Vorrichtung (9F), die für die auf die erste Einheitsproduktion (UJ1) folgende Einheitsproduktion (UJO) verwendet wird, abgegeben wird, und den zweiten Lieferabschnitt (43b), von dem aus die Vorrichtung (9F), die für die auf die auf die erste Einheitsproduktion (UJ1) folgende Einheitsproduktion (UJO) verwendet wird, abgegeben wird, unterscheidbar meldet.

8. Der Lagerschrank (40) nach Anspruch 5,
wobei der Führungsabschnitt (45) einen Bediener des ersten Lieferabschnitts (43a) benachrichtigt, aus dem die Zulieferungskomponente (9S), die für ein erstes Produktionszeitfenster (TM1) verwendet wird, in dem mindestens eine der Einheitenproduktionen (UJO) der zweiten Einheitenproduktion (UJ2) erfolgt, ausgegeben wird, und der erste Lieferabschnitt (43a), aus dem die Zulieferungskomponente (9S), die für ein zweites Produktionszeitfenster (TM2) verwendet wird, das später als das erste Produktionszeitfenster (TM1) liegt und in dem mindestens eine der Einzelproduktionen (UJO) der anderen Einzelproduktionen (UJO) der zweiten Einzelproduktion (UJ2) durchgeführt wird, unterscheidbar ausgegeben wird.

9. Der Lagerschrank (40) nach Anspruch 5 oder Anspruch 6,
wobei der Führungsabschnitt (45) einen Bediener des zweiten Auslieferungsabschnitts (43b) benachrichtigt, aus dem die Vorrichtung (9F), die für ein erstes Produktionszeitfenster (TM1) verwendet wird, in dem mindestens eine der Einheitenproduktionen (UJO) der zweiten Einheitenproduktion (UJ2) durchgeführt wird, ausgegeben wird und der zweite Lieferabschnitt (43b), aus der die Einrichtung (9F), die für ein zweites Produktionszeitfenster (TM2) verwendet wird, das später als das erste Produktionszeitfenster (TM 1) liegt und in dem mindestens eine der Einzelproduktionen (UJO) der anderen Einzelproduktionen (UJO) der zweiten Einzelproduktion (UJ2) durchgeführt wird, unterscheidbar ausgegeben wird.

10. Der Lagerschrank (40) nach einem der Ansprüche 5 bis 9,
wobei der Bewegungsabschnitt (44) die Zufuhrkomponente (9S), die für die erste Einheitsproduktion (UJO) verwendet wird, zu dem ersten Lieferabschnitt bewegt, und
wobei der Führungsabschnitt (45) einem Bediener den ersten Lieferabschnitt (43a), von dem aus die für die erste Einheitsproduktion (UJ1) verwendete Zulieferungskomponente (9S) abgegeben wird, und den ersten Lieferabschnitt (43a), von dem aus die für die zweite Einheitsproduktion (UJ2) verwendete Zulieferungskomponente (9S) abgegeben wird, unterscheidbar meldet.

11. Der Lagerschrank (40) nach einem der Ansprüche 1 bis 10,
wobei der Lieferabschnitt umfasst:
einen ersten Lieferabschnitt (43a), aus der die für die Einheitsproduktion (UJO) verwendete Zulieferungskomponente (9S) ausgeliefert wird; und
einen zweiten Lieferabschnitt (43b), aus der die Vorrichtung (9F) ausgegeben wird, die für die Einheitsproduktion (UJO) verwendet wird, die mit der Einheitsproduktion (UJO) identisch ist, für die die aus dem ersten Lieferabschnitt (43a) ausgegebene Zulieferungskomponente verwendet wird,
wobei der erste Lieferabschnitt (43a) und der zweite Lieferabschnitt (43b) zu einem fahrbaren Tisch (46) oder einem Gestell ausgebildet sind, das die Zulieferungskomponente (9S) und die Vorrichtung (9F) aufnehmen kann, und
wobei ein erster Identifizierungsabschnitt (48a), der zur Identifizierung des ersten Lieferabschnitts (43a) konfiguriert ist, und ein zweiter Identifizierungsabschnitt (48b), der zur Identifizierung des zweiten Lieferabschnitts (43b) konfiguriert ist, auf dem fahrbaren Tisch (46) oder dem Gestell (46) vorgesehen sind.

12. Der Lagerschrank (40) nach einem der Ansprüche 1 bis 10,
wobei der Lieferabschnitt (43) umfasst:
einen ersten Lieferabschnitt (43a), aus der die für die Einheitsproduktion (UJO) verwendete Zulieferungskomponente (9S) ausgeliefert wird; und
einen zweiten Lieferabschnitt (43b), aus der die Vorrichtung (9F) ausgegeben wird, die für die Einheitsproduktion (UJO) verwendet wird, die mit der Einheitsproduktion (UJO) identisch ist, für die die aus dem ersten Lieferabschnitt (43a) ausgegebene Zulieferungskomponente (9S) verwendet wird,
wobei der erste Lieferabschnitt (43a) zu einem ersten Rolltisch (46a) oder einem ersten Gestell (46a) ausgebildet ist, der das Zulieferteil (9S) aufnehmen kann,
wobei der zweite Lieferabschnitt (43b) zu einem zweiten Rolltisch (46b) oder einem zweiten Gestell (46b) ausgebildet ist, das die Vorrichtung (9F) aufnehmen kann,
wobei ein erster Identifikationsabschnitt (48a), der zum Identifizieren des ersten Lieferabschnitt (43a) konfiguriert ist, auf dem ersten Rolltisch (46a) oder dem ersten Gestell (46a) vorgesehen ist, und
wobei ein zweiter Identifikationsabschnitt (48b), der so konfiguriert ist, dass er den zweiten Lieferabschnitt (43b) identifiziert, auf dem zweiten Rollentisch (46b) oder dem zweiten Gestell (46b) vorgesehen ist.

## Revendications

1. Armoire de stockage (40) comprenant :
une première section de stockage (42a) configurée pour stocker un composant d'alimentation (9S) qui est au moins un d'un article (91) qui est fourni sur une carte (90) par une machine de travail sur carte (10) configurée pour exécuter un travail sur carte prédéterminé sur la carte (90) et la carte (90) avant que l'article (91) soit fourni sur celle-ci ;
une deuxième section de stockage (43a) configurée pour stocker un dispositif (9F) qui est fourni de manière amovible sur la machine de travail sur carte (10) à utiliser dans le travail sur carte ;
une section d'alimentation (43) configurée pour fournir de manière associée le composant d'alimentation (9S) et le dispositif (9F) qui sont utilisés pour une production d'unités prédéterminée (UJO) incluse dans un plan de production qui prescrit un ordre de productions d'unités (UJO) qui spécifient chacune une production d'un type identique de produits de carte (900) utilisant la machine de travail sur carte (10) ; et
une section de déplacement (44) configurée pour déplacer le composant d'alimentation (9S) stocké dans la première section de stockage (42a) vers la section d'alimentation (43) et déplace le dispositif (9F) stocké dans la deuxième section de stockage (43a) vers la section d'alimentation,
dans laquelle le dispositif (9F) et le composant d'alimentation (9S) sont accueillis ensemble dans un boîtier d'accueil (93).

2. L'armoire de stockage (40) selon la revendication 1,
dans laquelle la machine de travail sur carte (10) est un monteur de composants (10c) configuré pour monter un composant, qui constitue le composant d'alimentation, sur la carte (90), qui constitue le composant d'alimentation, et
dans laquelle un élément de maintien (95c), qui constitue le dispositif et est configuré pour prélever, maintenir et monter le composant sur la carte (90), et le composant, qui peut être maintenu par l'élément de maintien (95c), sont accueillis ensemble dans le boîtier d'accueil.

3. L'armoire de stockage (40) selon l'une quelconque des revendications 1 à 2,
dans laquelle la section de déplacement (44) est configurée pour déplacer le composant d'alimentation (9S) et le dispositif (9F) qui sont utilisés pour une deuxième production d'unités qui est au moins une des productions d'unités (UJO) intervenant après une première production d'unités (UJ1) qui est une des productions d'unité (UJO) dans lesquelles les produits de carte (900) sont produits par la machine de travail sur carte (10).

4. L'armoire de stockage (40) selon la revendication 3,
dans laquelle la section d'alimentation (43) comprend :
une première section d'alimentation (43) depuis laquelle le composant d'alimentation (9S) qui est utilisé pour la production d'unités (UJO) est fourni ; et
une deuxième section d'alimentation (43) depuis laquelle le dispositif (9F) qui est utilisé pour la production d'unités est fourni, la production d'unités (UJO) étant identique à la production d'unités (UJO) dans laquelle le composant d'alimentation (9S) est utilisé.

5. L'armoire de stockage (40) selon la revendication 4, comprenant en outre :
une section de guide (45) configurée pour notifier un opérateur de la première section d'alimentation (43a) depuis laquelle le composant d'alimentation (9S) qui est utilisé pour la deuxième production d'unités (UJ2) est fourni et la deuxième section d'alimentation (43b) depuis laquelle le dispositif (9F) qui est utilisé pour la deuxième production d'unités (UJ2) est fourni.

6. L'armoire de stockage (40) selon la revendication 5, dans laquelle la section de guide (45) notifie un opérateur de la première section d'alimentation (43a) depuis laquelle le composant d'alimentation (9S) qui est utilisé pour la production d'unités (UJO) après la première production d'unités (UJ1) est fourni et la première section d'alimentation (43a) depuis laquelle le composant d'alimentation (9S) qui est utilisé pour la production d'unités (UJO) intervenant après la production d'unités intervenant après la première production d'unités (UJ1) est fourni de manière distincte.

7. L'armoire de stockage (40) selon la revendication 5 ou 6,
dans laquelle la section de guide (45) notifie un opérateur de la deuxième section d'alimentation (43b) depuis laquelle le dispositif (9F) qui est utilisé pour la production d'unités (UJO) après la première production d'unités (UJ1) est fourni et la deuxième section d'alimentation (43b) depuis laquelle le dispositif (9F) qui est utilisé pour la production d'unités (UJO) intervenant après la production d'unités intervenant après la première production d'unités (UJ1) est fourni de manière distincte.

8. L'armoire de stockage (40) selon la revendication 5,
dans laquelle la section de guide (45) notifie un opérateur de la première section d'alimentation (43a) depuis laquelle le composant d'alimentation (9S) qui est utilisé pour un premier créneau de production (TM1), dans lequel au moins une des productions d'unités (UJO) de la deuxième production d'unités (UJ2) est exécutée, est fourni et la première section d'alimentation (43a) depuis laquelle le composant d'alimentation (9S) qui est utilisé pour un deuxième créneau de production (TM2), qui intervient après le premier créneau de production (TM1) et dans lequel au moins une production d'unités (UJO) des autres productions d'unités (UJO) de la deuxième production d'unités (UJ2) est exécutée, est fourni de manière distincte.

9. L'armoire de stockage (40) telle que revendiquée à la revendication 5 ou la revendication 6,
dans laquelle la section de guide (45) notifie un opérateur de la deuxième section d'alimentation (43b) depuis laquelle le dispositif (9F) qui est utilisé pour un premier créneau de production (TM1), dans lequel au moins une des productions d'unités (UJO) de la deuxième production d'unités (UJ2) est exécutée, est fourni et la deuxième section d'alimentation (43b) depuis laquelle le dispositif (9F) qui est utilisé pour un deuxième créneau de production (TM2), qui intervient après le premier créneau de production (TM1) et dans lequel au moins une production d'unités (UJO) des autres productions d'unités (UJO) de la deuxième production d'unités (UJ2) est exécutée, est fourni de manière distincte.

10. L'armoire de stockage (40) selon l'une quelconque des revendications 5 à 9,
dans laquelle la section de déplacement (44) déplace le composant d'alimentation (9S) qui est utilisé pour la première production d'unités (UJO) vers la première section d'alimentation, et
dans laquelle la section de guide (45) notifie un opérateur de la première section d'alimentation (43a) depuis laquelle le composant d'alimentation (9S) qui est utilisé pour la première production d'unité (UJ1) est fourni et la première section d'alimentation (43a) depuis laquelle le composant d'alimentation (9S) qui est utilisé pour la deuxième production d'unités (UJ2) est fourni de manière distincte.

11. L'armoire de stockage (40) selon l'une quelconque des revendications 1 à 10,
dans laquelle la section d'alimentation comprend :
une première section d'alimentation (43a) depuis laquelle le composant d'alimentation (9S) qui est utilisé pour la production d'unités (UJO) est fourni ; et
une deuxième section d'alimentation (43b) depuis laquelle le dispositif (9F) qui est utilisé pour la production d'unités (UJO) identique à la production d'unités (UJO) pour laquelle le composant d'alimentation fourni depuis la première section d'alimentation (43a) est utilisé, est fourni,
dans laquelle la première section d'alimentation (43a) et la deuxième section d'alimentation (43b) sont constituées dans un plateau sur roues (46) ou un châssis qui peut maintenir le composant d'alimentation (9S) et le dispositif (9F), et
dans laquelle une première section d'identification (48a) configurée pour identifier la première section d'alimentation (43a) et une deuxième section d'identification (48b) configurée pour identifier la deuxième section d'alimentation (43b) sont fournies sur le plateau sur roues (46) ou le châssis (46).

12. L'armoire de stockage (40) selon l'une quelconque des revendications 1 à 10,
dans laquelle la section d'alimentation (43) comprend :
une première section d'alimentation (43a) depuis laquelle le composant d'alimentation (9S) qui est utilisé pour la production d'unités (UJO) est fourni ; et
une deuxième section d'alimentation (43b) depuis laquelle le dispositif (9F) qui est utilisé pour la production d'unités (UJO) identique à la production d'unités (UJO) pour laquelle le composant d'alimentation (9S) fourni depuis la première section d'alimentation (43a) est utilisé, est fourni,
dans laquelle la première section d'alimentation (43a) est constituée dans un premier plateau sur roues (46a) ou un premier châssis (46a) qui peut maintenir le composant d'alimentation (9S),
dans laquelle la deuxième section d'alimentation (43b) est constituée dans un deuxième plateau sur roues (46b) ou un deuxième châssis (46b) qui peut maintenir le dispositif (9F),
dans laquelle une première section d'identification (48a) configurée pour identifier la première section d'alimentation (43a) est fournie sur le premier plateau à roues (46a) ou le premier châssis (46a), et
dans laquelle une deuxième section d'identification (48b) configurée pour identifier la deuxième section d'alimentation (43b) est fournie sur le deuxième plateau à roues (46b) ou le deuxième châssis (46b).
